(19) **Europäisches Patentamt / European Patent Office / Office européen des brevets**

(11) **EP 1 845 600 B1**

(12) **EUROPEAN PATENT SPECIFICATION**

(45) Date of publication and mention of the grant of the patent:
**26.02.2014 Bulletin 2014/09**

(51) Int Cl.:
**H02J 7/34** *(2006.01)*     **H03F 1/00** *(2006.01)*

(21) Application number: **07006062.9**

(22) Date of filing: **23.03.2007**

(54) **Amplification apparatus**

Verstärkungsvorrichtung

Appareil d'amplification

(84) Designated Contracting States:
**DE FR GB**

(30) Priority: **11.04.2006 JP 2006108783**

(43) Date of publication of application:
**17.10.2007 Bulletin 2007/42**

(73) Proprietor: **YAMAHA CORPORATION**
**Hamamatsu-shi**
**Shizuoka-ken (JP)**

(72) Inventor: **Noro, Masao**
**Hamamatsu-shi,**
**Shizuoka-ken (JP)**

(74) Representative: **HOFFMANN EITLE**
**Patent- und Rechtsanwälte**
**Arabellastrasse 4**
**81925 München (DE)**

(56) References cited:
**EP-A2- 1 478 083       WO-A1-97/31423**
**US-A1- 2005 172 139    US-B1- 6 798 177**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND OF THE INVENTION

The present invention relates to a technique for an amplification apparatus that amplifies and outputs a signal.

USB (Universal Serial Bus) standard terminals are widely employed for personal computers, and via these USB terminals, various types of peripheral devices can be connected, as needed, to personal computers.

Since a USB standard terminal includes a signal line and a power line, a peripheral device connected to a USB terminal can receive power via the power line. In this case, according to the USB standard, since the power provided is limited to a current of 0.5 A or lower, the upper limit of the available power is 2.5 W.

Since among the apparatuses that can be connected to a USB terminal, there are an apparatus that consumes power in excess of 2.5 W, a apparatus disclosed in patent document 1 that can cope with this problem has been proposed. According to the apparatus described in patent document 1, a capacitor is provided for an input unit that receives power from the power line of the USB terminal, and power accumulated in the capacitor is used to supplement the normally available power to satisfy peak power needs of the peripheral device connected to the USB terminal.

Patent Document 1: JP-T-2004-503199

However, since simply a capacitor is employed for the apparatus described in patent document 1, only a small charge can be accumulated on the capacitor. And since an extremely large capacitor would be required to increase the amount of the charge that can to be accumulated, this would adversely affect and hinder the downsizing of the apparatus. Especially for a USB amplifier that drives a small loudspeaker, connected to the USB terminal, the size would be increased, so that the amplifier may be no longer of no practical use.

Since an electric double layer type capacitor possessing a large capacitance has been developed, such a capacitor could be employed. However, because this type of capacitor has a high equivalent resistance and a correspondingly large power loss, such a capacitor could not be employed as a power source for an amplifier that drives a 4 to 8 ohm loudspeaker.

Further, a capacitor has been developed for which a large capacitance is provided by an increase in density, which permits a large current to be handled. But while for this capacitor the resistance is low, the withstand voltage is reduced to about 2 v, and thus the capacitor cannot be employed at the operating voltage of an amplifier. In this case, although the withstand voltage could be raised by connecting a plurality of capacitors in series, an additional circuit would be required to maintain a voltage balance, and the circuit structure would become complicated and the cost would be increased. As a result, such a capacitor is not practical for this type of use.

In US 6,798,177 B1 there is described a boost-buck cascade converter for pulsating loads. A power converter includes a first stage, a reservoir capacitor and a second stage. The first stage converts the voltage of a primary energy source, such as a battery, to a voltage on the reservoir capacitor, which stores a large amount of energy in the form of a voltage substantially larger than the voltage of the primary energy source. The second stage converts the voltage on the reservoir capacitor to a substantially constant voltage for a load device that demands current having the form of large, short, current pulses. The cascaded converter prevents the pulsating load currents of the load device, such as a GSM power amplifier, from causing a severe voltage loss at the battery. This increases the power available from the battery and reduces losses from the internal resistance of the battery.

In WO 97/31423 there is described a circuit for enhancing power delivery of an energy source. The power delivery of the energy source is enhanced by a dual function circuit. The circuit utilizes a store capacitor to store a voltage higher than the source voltage by transferring charge from the energy source to the storage capacitor between current pulses, then transferring charge from the storage capacitor to the load during current pulses. This is achieved by a combination of a boost converter operating in conjunction with a buck converter.

SUMMARY OF THE INVENTION

In order to solve these problems, one objective of the present invention is to provide an amplification apparatus that can perform driving using a high output supplied to compensate for peak power consumption, regardless of whether a power source that supplies low power is still at the maximum, and that can be compactly made.

In order to solve the above object, the present invention has the following arrangements.

(1) An amplification apparatus comprising:

a first DC-DC converter that raises a voltage of a DC power source supplied to an input side thereof and outputs power of the raised voltage;

a capacitor connected to an output side of the first DC-DC converter;

a second DC-DC converter that receives the power from the first DC-DC converter and the capacitor, drops a voltage of the received power and outputs the power of the dropped voltage;

an amplification circuit that amplifies a received signal;

a current detector that detects a current value of a current output by the DC power source; and

a switching circuit that selects between supplying the current from the DC power source to the amplification circuit when the current value detected by the current detector does not exceed a predetermined value, and supplying power output by the second DC-DC converter to the amplification circuit when the current value is greater than the predetermined value.

(2) The amplification apparatus according to (1) further comprising a third DC-DC converter arranged on a path along which a current is supplied by the DC power source to the amplification circuit for raising the voltage of the DC power source.

(3) The amplification apparatus according to (1), wherein the capacitor includes an electrolytic capacitor.

(4) The amplification apparatus according to (1), wherein the DC power source is a power source obtained through a power line provided at an output side of a USB standard terminal, and the received signal is a signal obtained through a signal line provide at the output side of the USB standard terminal.

(5) The amplification apparatus according to (4) further comprising a DA converter arranged on an input side of the amplification circuit for digital-analog converting the signal obtained through the signal line.

(6) A amplifying method for an amplification apparatus that includes a first DC-DC converter, a capacitor connected to an output side of the first DC-DC converter, a second DC-DC converter connected to the output side of the first DC-DC converter, and an amplification circuit connected to the second DC-DC converter, the method comprising:

raising a voltage of the DC power source supplied to an input side thereof and outputting power of the raised voltage by the first DC-DC converter;

receiving the power from the first DC-DC converter and the capacitor, dropping a voltage of the received power and outputting the power of the dropped voltage by the second DC-DC converter;

amplifying a received signal by the amplification circuit;

detecting the current value of the current output by the DC power source; and selecting between supplying the current from the DC power source to the amplification circuit when the current value detected by the current detector does not exceed a predetermined value, and supplying power output by the second DC-DC converter to the amplification circuit when the current value is greater than the predetermined value.

(7) The amplifying method according to (6) further comprising raising the voltage of the DC power source by a third DC-DC converter arranged on a path along which a current is supplied by the DC power source to the amplification circuit.

(8) The amplifying method according to (6), wherein the capacitor includes an electrolytic capacitor.

(9) The amplifying method according to (6), wherein the DC power source is a power source obtained through a power line provided at an output side of a USB standard terminal, and the received signal is a signal obtained through a signal line provide at the output side of the USB standard terminal.

(10) The amplifying method according to (9) further comprising digital-analog converting the signal obtained through the signal line by a DA converter arranged on an input side of the amplification circuit.

BRIEF DESCRIPTION OF THE DRAWINGS

Fig. 1 is a circuit diagram showing the arrangement of an amplification apparatus according to an example which is explained for an understanding of the present invention.

Fig. 2 is a circuit diagram showing an example circuit employed instead of a switching regulator in Fig. 1.

Fig. 3 is a circuit diagram showing an example circuit employed instead of the switching regulator in Fig. 1.

Fig. 4 is a circuit diagram showing the arrangement of an amplification apparatus according to an embodiment of the present invention.

Fig. 5 is a circuit diagram showing a modification of the embodiment in Fig. 4.
Fig. 6 is a circuit diagram showing an example circuit employed instead of a comparator shown in Figs. 4 and 5.

DETAILED DESCRIPTION OF PREFERRED EMBODIMENTS

The preferred embodiment of the present invention will now be described while referring to the drawings.

A: First Embodiment

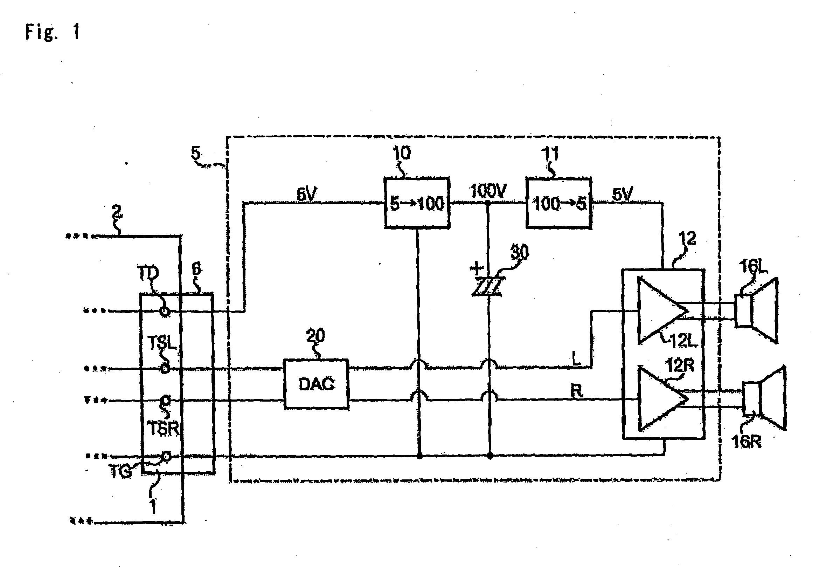

Fig. 1 is a circuit diagram showing a circuit of an amplification apparatus according to an example which is explained for an understanding of the present invention. In Fig. 1, a USB terminal 1 provided in a personal computer 2 includes a power terminal TD of 5 V, a ground terminal TG and stereo signal terminals TSL and TSR. An amplification apparatus 5 is connected to the USB terminal 1 via a USB plug 6.
When a voltage of 5 V is applied by the power terminal TD to the input terminal of a switching regulator 10, the switching regulator 10 raises this voltage to a direct current of 100V and outputs this direct current via an output terminal to a switching regulator 11 which drops the 100 V direct current to 5 V and outputs this voltage to an amplifier 12. In this case, the amplifier 12 is a 5 V amplifier in which are provided an amplifier 12L, for an L channel, and an amplifier 12R, for an R channel. Loudspeakers 16L and 16R are respectively connected to the amplifiers 12R and 12R.
A DA converter 20 converts digital signals output from the L channel and the R channel via the signal terminals TSL and TSR of the USB terminal 1, into analog signals, and transmits these signals to the input terminals of the amplifiers 12L and 12R.
An electrolytic capacitor 30 shown in Fig. 1 is located between the output side of the switching regulator 10 and the ground. The electrolytic capacitor 30 will now be described.

(Discharge period required for the electrolytic capacitor 30)

First, a discharge period required for the electrolytic capacitor 30 will be explained.
It is known that there is a large difference between a peak output of a musical tone signal and an average output thereof. This difference varies depending on music genres and music pieces, but generally, the average output is supposed to be 1/8 to 1/10 of the peak output. Relying on this relationship, it can be understood, if the peak power can be temporarily supplemented, the amplifier can be driven by 1/8 to 1/10 the maximum power at the peak all time other than when the power peak is reached. Further, through experiments performed by the present inventor, it was found that, regardless of the music genre, the length of a continuing peak power period was about 0.2 s.
Therefore, so long as the maximum power can be supplied for 0.2 s, at other times, the amplifier need only be driven by low power for music to be played at the same tonal volume as when the amplifier is driven by a large capacity power source. For example, when 20 W can be continuously supplied for 0.2 s, no problem is encountered if the average power, other than at the peak, is equal to or lower than 2.5 W. Thus, even with a power source satisfying the USB standard, the amplifier can be substantially driven by a power (in watts) of 20 W (10 W x 2 ch). That is, a discharge period for the electrolytic capacitor 30 is so designated that the maximum power can be maintained for a period of 0.2 s.

(Size of the electrolytic capacitor 30)

However, even in a case wherein for the power voltage a drop to 4 V is permitted, based on the assumption that an amplifier having a power voltage of 5 V is to be driven, an extremely large capacitance of about 0.8 F is required in order to supply 20 W for a period of 0.2 s. When this capacitance is provided by using an electrolytic capacitor having a capacitance of about 0.8 F (0.8 F = 800000 $\mu$F), there is too great an increase in the volume of the electrolytic capacitor 30 for it to be of practical use.
Therefore, according to this example, the size of the electrolytic capacitor 30 is reduced as follows.
First, charges Q which are accumulated in the electrolytic capacitor 30 are expressed by

$$Q = C \cdot V,$$

where C represents capacitance and V represents a voltage to be applied, and energy E is expressed by

$$E = C \cdot V^2/2.$$

As described above, in a case that a drop to 4 V is permitted for the power voltage supplied to the amplifier 12, a capacitor having a capacitance of about 0.8 F is required in order for 20 W to be supplied for a period of 0.2 s. When a voltage of 5 V has been accumulated in the capacitor of 0.8 F, the energy to be discharged before the voltage is dropped to 4 V is

$$0.8F \times 5V \times 5V \times 1/2 - 0.8F \times 4V \times 4V \times 1/2 = 3.6 \text{ J.}$$

Furthermore, based on the assumption that a case is one wherein 3.6 J of energy is accumulated using a voltage of 100 V, and that thereafter a very efficient switching regulator is employed to drop the voltage to 5 V, where C represents the capacitance required to discharge 3.6 J of energy, the following expression is satisfied:

$$C \times 100V \times 100V \times 1/2 - C \times 5V \times 5V \times 1/2 = 3.6J,$$

and the value of C that satisfies this expression is 722 $\mu$F.

The size of the electrolytic capacitor 30 is determined by the product of the capacitance and the voltage that is to be applied (C·V). Thus, when the 0.8 F at 5 V case is compared with the 722 $\mu$F at 100 V case,

    a: 0.8 x 5 = 4 (Q)
    b: 722 $\mu$ x 100 = 72200 $\mu$(Q) .

And the ratio for these two is

$$4 \ (Q)/72200 \ \mu(Q) = 55.4.$$

That is, it is found that the size of the electrolytic capacitor 30 can be reduced to about 1/55 that of the original. Specifically, 722$\mu$ can be easily obtained by arranging in parallel two electrolytic capacitors having a diameter of several tens millimeters.

As is apparent from the above description, the capacitance of the electrolytic capacitor 30 in Fig. 1 is set at about 722 $\mu$, and for this, two electrolytic capacitors of about 360 $\mu$F, having a diameter of ten-odd millimeters each, are arranged in parallel. In this case, since the electrolytic capacitor 30 is sufficiently small, the resultant amplification apparatus can be maintained as a small appropriate apparatus for connection to the USB terminal 1.

The operation of the amplification apparatus 5 having the above arrangement will now be described. First, when power is supplied by the USB terminal 1, the switching regulator 10 raises the voltage to 100 V, and charging of the electrolytic capacitor 30 is performed using this voltage value. After the charging has been completed, the switching regulator 11 drops the voltage of the power output by the switching regulator 10 and supplies the resultant power of 5 V to the amplifier 12.

In this state, when stereo signals are output for the L channel and the R channel, the DA converter converts these signals into analog signals that it transmits to the amplifiers 12L and 12R. The amplifiers 12L and 12R amplify the analog signals, and sounds for the left and right channels are output by the loudspeakers 16L and 16R.

Depending on the relationship between the gain of the amplifier and the values of the signals input to the amplifier 12, the power consumed by the amplifier 12 might exceed the maximum power that can be supplied by the power terminal TD of the USB terminal 1. Therefore, power exceeding the maximum power to be supplied can not be output by the switching regulator 10. In this example, when this state is encountered, the charge accumulated in the electrolytic capacitor 30 is supplementarily discharged to compensate for the shortage, and for use, the switching regulator 11 drops the power to 5 V.

Through this processing, when power exceeds the maximum power supplied by the USB terminal 1, the amplifier 12 can be driven continuously. At this time, when a signal input to the amplifier 12 maintains a peak value, power is still supplied to the amplifier 12 for a period of 0.2 s. Thus, for normal music, playing is continued without any problem. As a result, the maximum volume of 20 W (10 W x 2 ch) is substantially obtained.

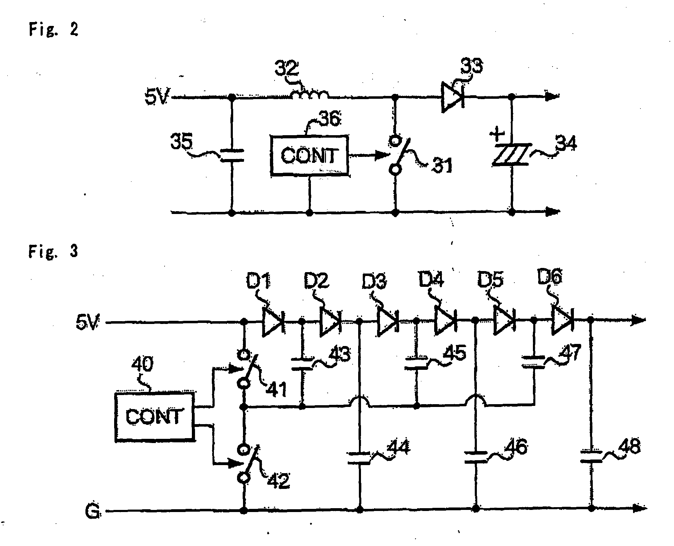

A boosting circuit including an inductor, shown in Fig. 2, may also be employed as the circuit for the switching regulator 10. Referring to Fig. 2, a controller 36 turns on or off a switch 31 to generate an induced current in the inductor 32, which then performs boosting. A rectifying diode 33, an electrolytic capacitor 34 used for smoothing, and a capacitor 35 for holding charges are also included in the circuit.

In addition, a rectifying circuit in Fig. 3 including diodes D1 to D6 and capacitors 43 to 48 may be employed as the circuit for the switching regulator 10. In this circuit, a controller 40 turns on or off switches 41 and 42, as needed, and the potentials of the capacitors 43 to 48 are superimposed to generate a high voltage.

B: Embodiment

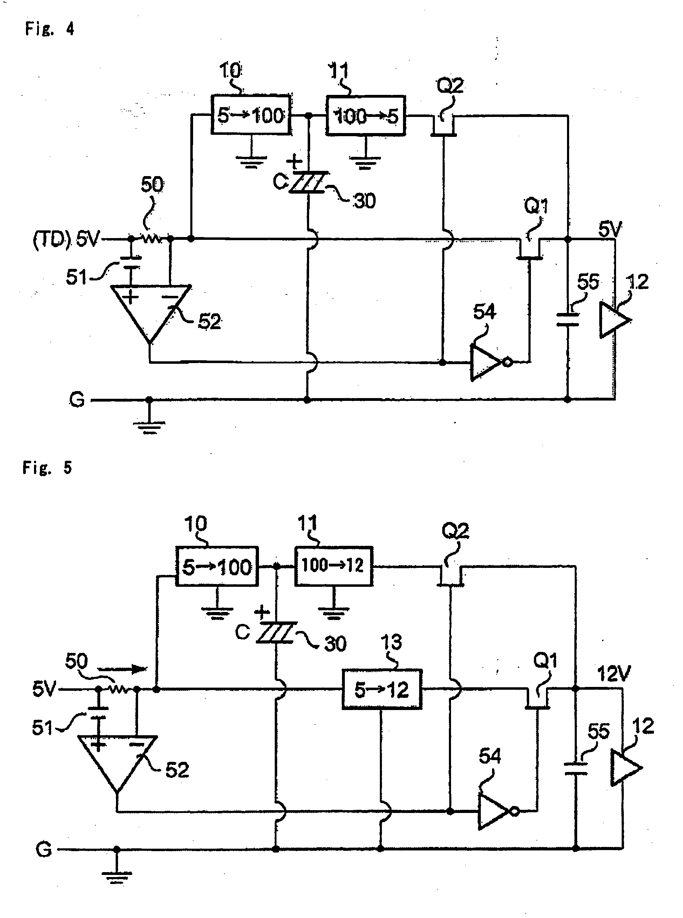

An embodiment according to the present invention will now be described. Fig. 4 is a circuit diagram showing the arrangement of the second embodiment of this invention. In Fig. 4, the same reference numerals as those used in Fig. 1 are employed to denote corresponding components, and no further explanation for them will be given.

In Fig. 4, one end of a current detection resistor 50 is connected to a power terminal TD for a USB terminal 1, and the other end is connected to the input side of a switching regulator 10 and also to the power terminal of an amplifier 12, via the drain and source of a transistor Q1. The output side of a switching regulator 11 is connected to the power terminal of the amplifier 12 via the drain and source of a transistor Q2.

A comparator 52 determines whether a current flowing across the current detection resistor 50 exceeds a predetermined value based on a voltage difference between the two terminals of the current detection resistor 50. A reference power source 51 generates a reference voltage. When the voltage drop at the current detection resistor 50 exceeds the voltage value for the reference power source 51, the comparator 52 outputs a signal at level H. The resistance of the current detection resistor 50 and the voltage value of the reference power source 51 are so designated that the comparator 52 outputs level H when the power consumed downstream of the current detection resistor 50 exceeds the maximum permissible value of the power consumed that conforms to the USB standard.

A signal output by the comparator 52 is transmitted to the gate of the transistor Q2 and to the gate of the transistor Q1, via an inverter 54. A capacitor 55 is located between the source of the transistor Q1 and the ground.

According to this arrangement, when power consumed by the amplifier does not exceed the power capacitance of the USB standard, the signal output by the comparator 52 is at level L, and therefore, the transistor Q2 is rendered off while the transistor Q1 is rendered on. As a result, the power is supplied to the amplifier 12 by the power terminal TD, via the transistor Q1. Further, in this state, since power in accordance with the USB standard still has more capacity, the charging of the electrolytic capacitor 30 is performed by the switching regulator 10.

When power consumed by the amplifier is increased, for example, at the signal peak time, the signal output by the comparator 52 goes to level H and the transistor Q2 is rendered on, while the transistor Q1 is rendered off. As a result, power is supplied to the amplifier 12 via the switching regulator 11 and the transistor Q2, and the discharge of the electrolytic capacitor 30 is performed to compensate for the shortage of power. Even when the peak signal is continued, the shortage of power can be compensated for in a maximum period of about 0.2 s.

Therefore, for normal music, playing can be continued without any problem. As a result, as in the first embodiment, a volume of a maximum 20 W (10 W x 2 ch) can be substantially obtained. Furthermore, in the second embodiment, when the power consumed does not exceed the maximum permissible power, power is supplied to the amplifier 12 via the current detection resistor 50 and the transistor Q1, without the switching regulators 10 and 11 being required. Thus, there no loss is caused by these components, and the efficiency with which power used is extremely high.

In this embodiment, when the power voltage of the amplifier 12 is higher than 5 V, e.g., when the power voltage is 12 V, as shown in Fig. 5, a switching regulator 13 that raises a voltage from 5 V to 12 V need only be located between the current detection resistor 50 and the drain of the transistor Q1. In this case, the voltage output by the switching regulator 11 may be dropped from 100 V to 12 V, in consonance with the power voltage of the amplifier 12.

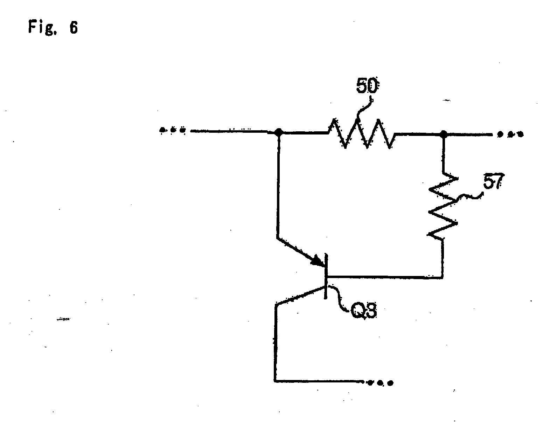

In addition, the comparator 52 and the reference power source 51 may be provided by using a circuit shown in Fig. 6. For a transistor Q3 shown in Fig. 6, the emitter is connected to one end of the current detection resistor 50, and the base is connected to the other end of the current detection resistor 50 via a bias resistor 57. The collector of the transistor Q3 corresponds to the output terminal of the comparator 52.

In the circuit in Fig. 6, appropriate resistances for the current detection resistor 50 and the bias resistor 57 should be designated relative to a voltage that is dropped in the forward direction between the base and emitter of the transistor Q3, and when the power consumed exceeds the maximum power consumed in accordance with the USB standard, the transistor Q1 should be turned on.

C: Modification

The embodiment of the present invention has been described; however, this invention is not limited to these embodiments, and can be carried out by various other embodiments.

Further, in the embodiments, as a power source, a power feed line extending from the output terminal conforming to the USB standard is employed. However, another power source (battery source) that supplies a smaller amount of power can also be employed.

Furthermore, in the embodiment, the electrolytic capacitor 30 has been employed. However, so long as the withstand voltage, the size and the capacitance are appropriate, another type of capacitor may also be employed. In the embodiment, the power consumed has been calculated based on the value of a current that flows via the current detection resistor 50. However, so long as the amount of power used on the output side of a power source (e.g., a USB power source) is obtained, any means can be employed.

## Claims

1. An amplification apparatus comprising:

   a first DC-DC converter (10) that raises a voltage of a DC power source supplied to an input side thereof and outputs power of the raised voltage;
   a capacitor (30) connected to an output side of the first DC-DC converter (10);
   a second DC-DC converter (11) that receives the power from the first DC-DC converter (10) and the capacitor (30), drops a voltage of the received power and outputs the power of the dropped voltage;
   an amplification circuit (12) that amplifies a received signal;
   **characterized by**
   a current detector (50) that detects a current value of a current output by the DC power source; and
   a switching circuit (52, 54, Q1, Q2) that selects between supplying the current from the DC power source to the amplification circuit (12) when the current value detected by the current detector (50) does not exceed a predetermined value, and supplying power output by the second DC-DC converter (11) to the amplification circuit (12) when the current value is greater than the predetermined value.

2. The amplification apparatus according to claim 1, further comprising a third DC-DC converter (13) arranged on a path along which a current is supplied by the DC power source to the amplification circuit (12) for raising the voltage of the DC power source.

3. The amplification apparatus according to claim 1, wherein the capacitor (30) includes an electrolytic capacitor.

4. The amplification apparatus according to claim 1, wherein the DC power source is a power source obtained through a power line (TD, TG) provided at an output side of a USB standard terminal, and the received signal is a signal obtained through a signal line (TSL, TSR) provided at the output side of the USB standard terminal.

5. The amplification apparatus according to claim 4, further comprising a DA converter arranged on an input side of the amplification circuit (12) for digital-analog converting the signal obtained through the signal line.

6. An amplifying method for amplification apparatus (5) that includes a first DC-DC converter (10), a capacitor (30) connected to an output side of the first DC-DC converter (10), a second DC-DC converter (11) connected to the output side of the first DC-DC converter (10), and an amplification circuit (12) connected to the second DC-DC converter, the method comprising:

   raising a voltage of the DC power source supplied to an input side thereof and outputting power of the raised voltage by the first DC-DC converter (10);
   receiving the power from the first DC-DC converter (10) and the capacitor (30), dropping a voltage of the received power and outputting the power of the dropped voltage by the second DC-DC converter (11);
   amplifying a received signal by the amplification circuit (12);
   **characterized by**
   detecting the current value of the current output by the DC power source in a current detector (50); and
   selecting between supplying the current from the DC power source to the amplification circuit (12) when the current value detected by the current detector (50) does not exceed a predetermined value, and supplying power output by the second DC-DC converter (11) to the amplification circuit (12) when the current value is greater than the predetermined value.

7. The amplifying method according to claim 6, further comprising raising the voltage of the DC power source by a third DC-DC converter (13) arranged on a path along which a current is supplied by the DC power source to the amplification circuit (12).

8. The amplifying method according to claim 6, wherein the capacitor (30) includes an electrolytic capacitor.

9. The amplifying method according to claim 6, wherein the DC power source is a power source obtained through a power line (TD, TG) provided at an output side of a USB standard terminal, and the received signal is a signal obtained through a signal line (TSL, TSR) provided at the output side of the USB standard terminal.

10. The amplifying method according to claim 9, further comprising digital-analog converting the signal obtained through the signal line by a DA converter arranged on an input side of the amplification circuit (12).


**Patentansprüche**

1. Verstärkungsvorrichtung, umfassend:

einen ersten Gleichspannungsumrichter (10), der eine Spannung einer Gleichstromquelle erhöht, die seiner Eingangsseite zugeführt wird, und Strom mit der höheren Spannung ausgibt;
einen Kondensator (30), der an eine Ausgangsseite des ersten Gleichspannungsumrichters (10) angeschlossen ist;
einen zweiten Gleichspannungsumrichter (11), der den Strom von dem ersten Gleichspannungsumrichter (10) und dem Kondensator (30) empfängt, und eine Spannung des empfangenen Stromes absenkt und den Strom mit der abgesenkten Spannung ausgibt;
einen Verstärkungsschaltkreis (12), der ein empfangenes Signal verstärkt;
**gekennzeichnet durch**
einen Stromdetektor (50), der einen Stromwert eines Stromes erfasst, der **durch** die Gleichstromquelle ausgegeben wird; und
einen Schaltstromkreis (52, 54, Q1, Q2), der zwischen dem Zuführen des Stromes von der Gleichstromquelle zu dem Verstärkungsschaltkreis (12), wenn der Stromwert, der **durch** den Stromdetektor (50) erfasst wird, einen vorbestimmten Wert nicht übersteigt, und dem Zuführen von Strom auswählt, der **durch** den zweiten Gleichspannungsumrichter (11) zu dem Verstärkungsschaltkreis (12) ausgegeben wird, wenn der Stromwert größer als der vorbestimmte Wert ist.

2. Verstärkungsvorrichtung nach Anspruch 1, des Weiteren einen dritten Gleichspannungsumrichter (13) umfassend, der auf einem Pfad angeordnet ist, auf dem ein Strom durch die Gleichstromquelle dem Verstärkungsschaltkreis (12) zugeführt wird, um die Spannung der Gleichstromquelle zu erhöhen.

3. Verstärkungsvorrichtung nach Anspruch 1, wobei der Kondensator (30) einen elektrolytischen Kondensator aufweist.

4. Verstärkungsvorrichtung nach Anspruch 1, wobei die Gleichstromquelle aus einer Stromquelle besteht, die durch eine Stromleitung (TD, TG) hindurch an einer Ausgangsseite eines standardmäßigen USB-Anschlusses zur Verfügung gestellt wird, und das empfangene Signal aus einem Signal besteht, das durch eine Signalleitung (TSL, TSR) hindurch erhalten wird, die an der Ausgangsseite des standardmäßigen USB-Anschlusses zur Verfügung gestellt wird.

5. Verstärkungsvorrichtung nach Anspruch 4, des Weiteren einen Digital-Analog-Umsetzer umfassend, der an einer Eingangsseite des Verstärkungsschaltkreises (12) angeordnet ist, um das Signal digital-analog umzusetzen, das durch die Signalleitung hindurch erhalten wird.

6. Verstärkungsverfahren für eine Verstärkungsvorrichtung (5), die einen ersten Gleichspannungsumrichter (10), einen Kondensator (30), der an eine Ausgangsseite des ersten Gleichspannungsumrichters (10) angeschlossen ist, einen zweiten Gleichspannungsumrichter (11), der an die Ausgangsseite des ersten Gleichspannungsumrichters (10) angeschlossen ist, und einen Verstärkungsschaltkreis (12) aufweist, der an den zweiten Gleichspannungsumrichter angeschlossen ist, wobei das Verfahren umfasst:

Erhöhen einer Spannung der Gleichstromquelle, die seiner Eingangsseite zugeführt wird, und Ausgeben von Strom mit der höheren Spannung durch den ersten Gleichspannungsumrichter (10);
Empfangen des Stromes von dem ersten Gleichspannungsumrichter (10) und dem Kondensator (30), Absenken einer Spannung des empfangenen Stromes und Ausgeben des Stromes mit der abgesenkten Spannung durch den zweiten Gleichspannungsumrichter (11);

Verstärken eines empfangenen Signals durch den Verstärkungsschaltkreis (12);

**gekennzeichnet durch**

Erfassen des Stromwertes des Stromes, der **durch** die Gleichstromquelle ausgegeben wird, in einem Stromdetektor (50); und

Auswählen zwischen dem Zuführen des Stromes von der Gleichstromquelle zu dem Verstärkungsschaltkreis (12), wenn der Stromwert, der **durch** den Stromdetektor (50) erfasst wird, einen vorbestimmten Wert nicht übersteigt, und dem Zuführen von Strom, der **durch** den zweiten Gleichspannungsumrichter (11) an den Verstärkungsschaltkreis (12) ausgegeben wird, wenn der Stromwert größer als der vorbestimmte Wert ist.

7. Verstärkungsverfahren nach Anspruch 6, des Weiteren das Erhöhen der Spannung der Gleichstromquelle durch einen dritten Gleichspannungsumrichter (13) umfassend, der auf einem Pfad angeordnet ist, auf dem ein Strom durch die Gleichstromquelle dem Verstärkungsschaltkreis (12) zugeführt wird.

8. Verstärkungsverfahren nach Anspruch 6, wobei der Kondensator (30) einen elektrolytischen Kondensator aufweist.

9. Verstärkungsverfahren nach Anspruch 6, wobei die Gleichstromquelle aus einer Stromquelle besteht, die durch eine Stromleitung (TD, TG) hindurch erhalten wird, die an einer Ausgangsseite eines standardmäßigen USB-Anschlusses zur Verfügung gestellt wird, und das empfangene Signal, aus einem Signal besteht, das durch eine Signalleitung (TSL, TSR) hindurch erhalten wird, die an der Ausgangsseite des standardmäßigen USB-Anschlusses zur Verfügung gestellt wird.

10. Verstärkungsverfahren nach Anspruch 9, des Weiteren das Digital-Analog-Umsetzen des Signales umfassend, das durch die Signalleitung hindurch von einem Digital-Analog-Umsetzer erhalten wird, der an einer Eingangsseite des Verstärkungsschaltkreises (12) angeordnet ist.

**Revendications**

1. Appareil d'amplification comprenant :

un premier convertisseur continu-continu (10) qui élève une tension d'une source d'alimentation c.c. fournie à son côté d'entrée et sort une puissance de la tension élevée ;

un condensateur (30) connecté à un côté de sortie du premier convertisseur continu-continu (10) ;

un deuxième convertisseur continu-continu (11) qui reçoit la puissance du premier convertisseur continu-continu (10) et du condensateur (30), abaisse une tension de la puissance reçue et sort la puissance de la tension abaissée ;

un circuit d'amplification (12) qui amplifie un signal reçu ;

**caractérisé par**

un détecteur de courant (50) qui détecte une valeur de courant d'un courant sorti par la source d'alimentation c.c. ; et

un circuit de commutation (52, 54, Q1, Q2) qui sélectionne entre la fourniture du courant de la source d'alimentation c.c. au circuit d'amplification (12) lorsque la valeur de courant détectée par le détecteur de courant (50) ne dépasse pas une valeur prédéterminée, et la fourniture de puissance sortie par le deuxième convertisseur continu-continu (11) au circuit d'amplification (12) lorsque la valeur de courant est supérieure à la valeur prédéterminée.

2. Appareil d'amplification selon la revendication 1, comprenant en outre un troisième convertisseur continu-continu (13) agencé sur un trajet le long duquel un courant est fourni par la source d'alimentation c.c. au circuit d'amplification (12) pour élever la tension de la source d'alimentation c.c..

3. Appareil d'amplification selon la revendication 1, dans lequel le condensateur (30) comprend un condensateur électrolytique.

4. Appareil d'amplification selon la revendication 1, dans lequel la source d'alimentation c.c. est une source d'alimentation obtenue par l'intermédiaire d'une ligne d'alimentation (TD, TG) pourvue au niveau d'un côté de sortie d'une borne de norme USB, et le signal reçu est un signal obtenu par l'intermédiaire d'une ligne de signaux (TSL, TSR) pourvue au niveau du côté de sortie de la borne de norme USB.

**5.** Appareil d'amplification selon la revendication 4, comprenant en outre un convertisseur N-A agencé sur un côté d'entrée du circuit d'amplification (12) pour la conversion numérique-analogique du signal obtenu par l'intermédiaire de la ligne de signaux.

**6.** Procédé d'amplification pour un appareil d'amplification (5) qui comprend un premier convertisseur continu-continu (10), un condensateur (30) connecté à un côté de sortie du premier convertisseur continu-continu (10), un deuxième convertisseur continu-continu (11) connecté au côté de sortie du premier convertisseur continu-continu (10), et un circuit d'amplification (12) connecté au deuxième convertisseur continu-continu, le procédé comprenant :

l'élévation d'une tension de la source d'alimentation c.c. fournie à son côté d'entrée et la sortie de la puissance de la tension élevée par le premier convertisseur continu-continu (10) ;
la réception de la puissance du premier convertisseur continu-continu (10) et du condensateur (30), l'abaissement d'une tension de la puissance reçue et la sortie de la puissance de la tension abaissée par le deuxième convertisseur continu-continu (11) ;
l'amplification d'un signal reçu par le circuit d'amplification (12) ;
**caractérisé par**
la détection de la valeur de courant du courant sorti par la source d'alimentation c.c. dans un détecteur de courant (50) ; et
la sélection entre la fourniture du courant de la source d'alimentation c.c. au circuit d'amplification (12) lorsque la valeur de courant détectée par le détecteur de courant (50) ne dépasse pas une valeur prédéterminée, et la fourniture de puissance sortie par le deuxième convertisseur continu-continu (11) au circuit d'amplification (12) lorsque la valeur de courant est supérieure à la valeur prédéterminée.

**7.** Procédé d'amplification selon la revendication 6, comprenant en outre l'élévation de la tension de la source d'alimentation c.c. par un troisième convertisseur continu-continu (13) agencé sur un trajet le long duquel un courant est fourni par la source d'alimentation c.c. au circuit d'amplification (12).

**8.** Procédé d'amplification selon la revendication 6, dans lequel le condensateur (30) comprend un condensateur électrolytique.

**9.** Procédé d'amplification selon la revendication 6, dans lequel la source d'alimentation c.c. est une source d'alimentation obtenue par l'intermédiaire d'une ligne d'alimentation (TD, TG) pourvue au niveau d'un côté de sortie d'une borne de norme USB, et le signal reçu est un signal obtenu par l'intermédiaire d'une ligne de signaux (TSL, TSR) pourvue au niveau du côté de sortie de la borne de norme USB.

**10.** Procédé d'amplification selon la revendication 9, comprenant en outre la conversion numérique-analogique du signal obtenu par l'intermédiaire de la ligne de signaux par un convertisseur N-A agencé sur un côté d'entrée du circuit d'amplification (12).

Fig. 1

EP 1 845 600 B1

Fig. 2

Fig. 3

Fig. 4

Fig. 5

Fig. 6

**EP 1 845 600 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004503199 T
- US 6798177 B1
- WO 9731423 A